# NEUE EUROPÄISCHE PATENTSCHRIFT

(11) **EP 3 066 432 B2**
(45) Veröffentlichungstag und Bekanntmachung des Hinweises auf die Entscheidung über den Einspruch: **06.09.2023**
(45) Hinweis auf die Patenterteilung: 31.01.2018
(21) Anmeldenummer: 14789528.8
(22) Anmeldetag: 22.10.2014
(51) Int. Cl.: G01G 21/28, G01G 23/48

(54) **KOMPARATORWAAGE MIT ABNEHMBAREM KLIMAMODUL**
MASS COMPARATOR HAVING REMOVABLE CLIMATE MODULE
BALANCE À COMPARATEUR COMPORTANT UN MODULE DE CLIMATISATION AMOVIBLE

(30) Priorität: 08.11.2013 DE 102013018767; 07.02.2014 DE 102014101565
(43) Veröffentlichungstag der Anmeldung: 14.09.2016
(73) Patentinhaber: Sartorius Lab Instruments GmbH & Co. KG, 37079 Göttingen (DE)
(72) Erfinder: ESSER, Richard, 37120 Bovenden - Eddigehausen (DE); HOLST, Heyko, 37085 Göttingen (DE); MÜHLICH, Sigo, 37120 Bovenden (DE); HILBRUNNER, Falko, 98693 Ilmenau (DE); FEHLING, Thomas, 37218 Witzenhausen (DE); GATZEMEIER, Benno, 37085 Göttingen (DE); GUNKEL, Rainer, 37308 Schimberg (DE)
(74) Vertreter: Prinz & Partner mbB
(86) Internationale Anmeldenummer: PCT/EP2014/002855
(87) Internationale Veröffentlichungsnummer: WO 2015/067352

(56) Entgegenhaltungen:
- WO-A1-2013/163612
- DE-A1- 3 106 534
- DE-A1- 10 326 469
- DE-A1-102010 042 621
- DE-U1- 20 001 455
- DE-U1- 29 912 867
- DE-U1-202004 000 590
- US-B2- 9 354 109

## Beschreibung

Die Erfindung betrifft eine Komparatorwaage und ein Verfahren zum Betreiben einer Komparatorwaage mit einem Wägeraum, der durch einen Windschutz zur Umgebung hin abgetrennt ist.

Elektronische Komparatorwaagen, die die vorliegende Erfindung betrifft, arbeiten mit einer Vergleichsmessung. In mehreren Wägevorgängen wird eine bekannte Masse als Referenzobjekt mit der Masse eines Prüflings verglichen. Solche Prüflinge sind insbesondere Referenzmassen für andere Waagen. Die vorliegende Erfindung betrifft insbesondere hochauflösende elektronische Komparatorwaagen für Massevergleiche, z.B. in den Genauigkeitsklassen E1 bis F2 nach OIML R 111-1. Für diese Massevergleiche wird die Luftdichte mit Hilfe externen Klimasensoren bestimmt, die die Auftriebskraft der Gewichtsstücke, das heißt des Wägeguts, beeinflusst.

Für Komparatorwaagen ist bekannt, dass der Luftauftrieb durch eine Vergleichsmessung zwischen zwei Referenzobjekten bestimmt wird, deren Masse und Dichte vorbekannt sind.

Es ist auch bekannt, dass Temperatur, Luftdruck und Feuchte auch die Waage selbst beeinflussen, insbesondere die Wägezelle. Aus diesem Grund werden zur Kompensation der Veränderungen der Waagenanzeige bei veränderten Umgebungsparametern Korrekturfaktoren im Gerät abgelegt, zum Beispiel in Form von Kurven oder Tabellen. Hierzu werden insbesondere im Bereich der Wägezelle Temperatur- und Luftfeuchtesensoren angeordnet, über die dann eine Korrektur der Waage selbst in Abhängigkeit von den sich ändernden Umgebungsbedingungen, auch Klimaänderungen genannt, automatisch erfolgt.

So beschreibt die DE 37 14 540 C2 ein Verfahren zum automatischen Kalibrieren einer hochauflösenden, elektronischen Waage, bei der für die Kalibrierung der Waage selbst Umgebungseinflüsse wie Temperaturänderung und Feuchtigkeitsänderung herangezogen werden, die extern erfasst werden. Der entsprechende Kalibrierfaktor wird von einem Computer ermittelt und korrigiert das Wägeresultat.

Aus der DE 299 12 867 U1 ist eine Analysenwaage mit Messwertaufnehmer für Umgebungsparameter bekannt, bei der eine Anzeige auf der Rückwand des Wägeraums vorgesehen ist. In dieser Anzeige werden die Temperatur im Wägeraum und die Luftfeuchte im Wägeraum angezeigt sowie allgemein der generell herrschende Luftdruck. Es wird dabei davon ausgegangen, dass bei einer feuchten Luft eine Feuchtebelegung der Oberfläche des Wägeguts erfolgt, die abhängig von den Änderungen der Luftfeuchte ist. Somit ist die Bedienperson über die Anzeige darüber informiert, dass beispielsweise bei sich ändernder Luftfeuchte das Wägegut länger im Wägeraum liegen sollte, um einen stabilen Endwert der Feuchtebelegung zu erreichen. Ergeben sich starke Luftdruckänderungen, so kann die Bedienperson eine sogenannte Auftriebskorrektur vornehmen, indem sie die angezeigten Daten über eine Eingabeeinheit dem Prozessor in der Waage liefert. Was die Temperatur anbelangt, so dient diese dazu, die Abweichung von der Referenztemperatur zu ermitteln und entsprechende Korrekturfaktoren zu berücksichtigen.

Schließlich gibt es auch klimatisierte Messräume, in denen Präzisionswaagen stehen, in die die Klimadaten des Messraumes eingegeben werden. Die Klimadaten aus der Klimaanlage oder deren Sensoren werden manuell oder automatisch in die Waage eingespeist.

Aufgabe der Erfindung ist es, eine Komparatorwaage zu schaffen, die kompakt ist und mit geringerem Aufwand eine verbesserte Messgenauigkeit gewährleistet.

Zur Lösung dieser Aufgabe ist erfindungsgemäß eine Komparatorwaage vorgesehen, mit einem Wägeraum, einem Windschutz, der den Wägeraum umgibt, einem Klimamodul, das einen Luftdrucksensor, einen Luftfeuchtesensor und einen Lufttemperatursensor enthält und abnehmbar in dem Wägeraum angeordnet ist, einem Prozessor, der in der Komparatorwaage angeordnet ist, einer Dateneingabeeinheit, die an der Komparatorwaage angeordnet ist, und einer Datenübertragungsstrecke, die ausgebildet ist, Daten zwischen dem Klimamodul und dem Prozessor auszutauschen. Es ist vorgesehen, dass der Prozessor so ausgebildet ist, dass er auf Basis der Dichte des Wägeguts aus dem Luftdruck, der Luftfeuchte und der Lufttemperatur im Wägeraum den Luftauftrieb zumindest des Prüflings sowie den Auftriebskorrekturfaktor ermittelt. Auf diese Weise können vom Klimamodul metrologisch rückführbare Klimawerte zeitsynchron zur Übernahme des Massewertes erhalten werden, mit denen der Prozessor in der Lage ist, den Wägewert zu korrigieren.

Die Erfindung beruht auf dem Grundgedanken, sämtliche Bauteile und Funktionen, die für eine Klimakompensation von Wägewerten nötig sind, in der Komparatorwaage zu vereinen. Es sind daher keine externen Computer, Sensoren, etc. notwendig. Stattdessen kann dem Benutzer ein kompaktes Messlabor an die Hand gegeben werden, das sogar transportabel ausgeführt sein kann. Da das Klimamodul austauschbar (also zerstörungsfrei von der Waage lösbar) ist, kann es nach Bedarf zu einem externen Institut bzw. Dienstleister zum Kalibrieren geschickt werden. In der Zwischenzeit kann die Komparatorwaage weiter betrieben werden, indem ein Austausch-Klimamodul eingesetzt wird. Es kann also immer rollierend eines oder (bei mehreren Komparatorwaagen) mehrere der Klimamodule beim Kalibrieren sein, während mit den übrigen Klimamodulen gemessen wird.

Hinsichtlich des Klimamoduls ergibt sich als weiterer Vorteil, dass ältere Waagen nachgerüstet werden können. Es muss hierzu neben der Datenübertragungsstrecke lediglich die Software des Prozessors ergänzt werden.

Hinsichtlich der Genauigkeit hat die erfindungsgemäße Komparatorwaage den Vorteil, dass die Klimadaten im Windschutz (und nicht nur in dem Raum, in dem sich die Waage befindet) gemessen werden. Es wird also exakt die für den Auftrieb relevante Luftdichte ermittelt wird. Außerdem können, da die Auftriebswerte automatisch an den Prozessor übersandt werden, Übertragungsfehler praktisch ausgeschlossen werden, wie sie beim Übertragen von Werten aus dem sogenannten Kalibrierschein in die Kalibriersoftware nach der DE 299 12 867 U1 möglich sind.

Gemäß einer Ausführungsform ist vorgesehen, dass das Klimamodul mittels einer elektrischen Steckverbindung mit dem Prozessor verbunden ist. Die Steckverbindung kann in eine mechanische Aufnahme integriert sein, die zur Anbringung des Klimamoduls an der Präzisionswaage dient. Auf diese Weise wird die Datenübertragungsstrecke zum Prozessor automatisch dann erstellt, wenn das Klimamodul innerhalb des Windschutzes an seinem Platz angeordnet wird.

Gemäß einer alternativen Ausführungsform ist vorgesehen, dass das Klimamodul mittels einer Funkübertragung mit dem Prozessor gekoppelt ist. In diesem Fall kann das Klimamodul an einer beliebigen Stellen innerhalb des Windschutzes angeordnet werden, beispielsweis an einer Begrenzungswand, an der es am wenigsten stört, ohne dass darauf Rücksicht genommen werden muss, ob an dieser Stelle sinnvoll eine Steckverbindung angeordnet werden kann. Außerdem ist der Verzicht auf eine Steckverbindung dahingehend vorteilhaft, dass der Innenraum der Wägekabine glatter und damit bessere reinigbar ausgeführt werden kann. Das Klimamodul enthält einen Luftdrucksensor, einen Luftfeuchtesensor und einen Lufttemperatursensor. Mit diesen Sensoren können die für eine präzise Messung wesentlichen Klimadaten aufgenommen werden.

Es kann zusätzlich vorgesehen sein, dass innerhalb des Klimamoduls ein Sensor, welcher mit dem Prozessor gekoppelt ist, vorhanden ist und ausgebildet ist, den Ionisationsgrad im Wägeraum zu bestimmen. Dadurch kann ein zusätzlicher Parameter bestimmt und bei der Korrektur des Wägewerts berücksichtigt werden. Abhängig von dem bestimmten Ionisationsgrad wird vom Prozessor ein Ausgangssignal erzeugt, z.B. um den Ionisationsgrad aktiv zu verändern, indem eine Ionisationseinrichtung verwendet wird, die ab Erreichen bestimmter Ionisationsgrade aktiviert wird. Ferner kann auch eine Anzeige dem Benutzer darauf hinweisen, dass der Ionisationsgrad innerhalb des Wägeraumes zu hoch ist und entladen werden sollte.

Es kann auch vorgesehen sein, dass ein Lichtsensor im Klimamodul vorhanden ist, welcher mit dem Prozessor gekoppelt ist. Dadurch kann ein wiederum weiterer Parameter bestimmt und bei der Korrektur des Wägewerts berücksichtigt werden. Der Prozessor kann ab einem vorgegebenen Lichteinfall ein Ausgangssignal abgeben. Der Einfluss des Lichteinfalls auf den Wägeprozess ist damit bestimmbar, um gegebenenfalls Maßnahmen im Prozess selbst zu ergreifen. Das Ausgangssignal kann auch eine Anzeige sein.

Gemäß einer Ausführungsform ist innerhalb des Klimamoduls ein elektronischer Speicher vorgesehen, insbesondere ein EEPROM, der von außen auslesbar ist und auf dem Kalibrierwerte und Korrekturwerte für das Klimamodul abgelegt werden können. Zum Justieren können die Kalibrierwerte auf einem elektronischen Speicher auf dem Klimamodul abgelegt werden, insbesondere auf einem EEPROM. Dies geschieht bei einem externen Dienstleister. Wenn das Klimamodul dann wieder an die Komparatorwaage angekoppelt wird, stehen diese Daten dem Prozessor der Waage unmittelbar zur Verfügung. Zusätzlich können auf dem Speicher unter anderem zumindest einige der folgenden Informationen zur Sensorkalibrierung abgelegt werden: Nummer des Kalibrierscheins, aktuelle Kalibrierwerte, Kalibrierdatum, Name des Kalibrierlabors und des Bearbeiters sowie Kalibrierhistorie. Auf dem Speicher des Klimamoduls können auch sogenannte Unsicherheitswerte für jede Klimagröße abgelegt sein, sodass zum Beispiel zur Berechnung der Luftdichte ebenso die Berechnung der Unsicherheit der Luftdichte durch die Komparatorwaage erfolgt.

Gemäß einer Ausgestaltung ist vorgesehen, dass das Klimamodul auch außerhalb einer Waage als selbständige Einheit einsetzbar ist und über einen I²C-Bus an einen USB-Port eines PC anschließbar ist. Dies erleichtert das externe Kalibrieren. Außerdem kann das Klimamodul in anderen Anwendungen dafür eingesetzt werden, Klimagrößen aufzunehmen, ohne dass es an eine Waage angeschlossen ist. Die Leiterplatte des Klimamoduls kann hierfür mit geringem Aufwand einen Steckfortsatz aufweisen, um an einen USB-Adapter angeschlossen werden zu können.

Zur Lösung der oben genannten Aufgabe ist ferner ein Verfahren zum Betreiben einer Komparatorwaage vorgesehen, mit einem Wägeraum, der durch einen Windschutz zur Umgebung hin abgetrennt ist und in dem ein Luftdrucksensor, ein Luftfeuchtesensor und ein Lufttemperatursensor angeordnet sind, wobei die Sensoren mit einem Prozessor gekoppelt sind und wobei Wägegut in Form eines Prüflings und wenigstens eines Referenzgewichts gewogen wird. Dabei ist vorgesehen, dass der Luftdruck, die Luftfeuchte und die Lufttemperatur im Wägeraum mithilfe der Sensoren ermittelt werden. Außerdem wird die Dichte des Wägeguts, dessen Masse zu bestimmen ist, in die Komparatorwaage eingegeben. Weiterhin wird der Luftauftrieb zumindest des Prüflings sowie der Auftriebskorrekturfaktors aus dem Luftdruck, der Luftfeuchte, der Lufttemperatur und der Dichte des Wägegutes ermittelt. Schließlich wird der korrigierte, konventionelle Wägewerts des Prüflings bestimmt.

Das erfindungsgemäße Verfahren bestimmt die aktuelle Luftdichte beim Wiegevorgang aus zahlreichen Parametern im Wägeraum und nicht nur, wie dies bei der DE 299 12 867 U1 vorgeschlagen ist, anhand des Luftdrucks. Über die tatsächliche aktuelle Luftdichte und die Dichte des Wägeguts werden der Luftauftrieb zumindest des Prüflings sowie der Auftriebskorrekturfaktor und damit die korrigierte, konventionelle Masse ermittelt. Bis auf die Dichteeingabe erfolgen alle anderen Dateneingaben automatisch, d.h. es werden weder Temperatur, Luftfeuchtigkeit noch Luftdruck manuell in den Prozessor eingegeben, die Daten gelangen elektronisch über die Sensoren in den Prozessor.

Es werden nicht zwingend (was nicht ausgeschlossen ist) zur Dichtebestimmung zwei verschiedene Referenzgewichte oder Referenzkörper eingesetzt, vielmehr kann auch mit einem Referenzgewicht gearbeitet werden.

Eine zusätzliche Kompensation der ermittelten Werte wegen Änderungen innerhalb der Wägezelle aufgrund von Klimaänderungen kann natürlich auch vorgenommen werden.

Die Messung der entsprechenden Daten zur Ermittlung des Auftriebs im Windschutz hat den Vorteil, dass exakt die für den Auftrieb relevante Luftdichte ermittelt wird.

Dadurch, dass die Auftriebswerte an den Prozessor automatisch übersandt werden, können Übertragungsfehler praktisch ausgeschlossen werden, wie sie beim Übertragen von Werten aus dem sogenannten Kalibrierschein in die Kalibriersoftware nach der DE 299 12 867 U1 möglich sind.

Nicht nur der Luftauftrieb des Wägeguts, dessen Gewicht zu ermitteln ist, sondern auch der Luftauftrieb des Referenzgewichts wird aus dem Luftdruck, der Luftfeuchte und der Lufttemperatur sowie der Dichte des Referenzgewichts ermittelt, um die um ihren Luftauftrieb korrigierte Masse des Referenzgewichts zu bestimmen.

Zusätzlich kann vorgesehen sein, dass der Ionisationsgrad im Wägeraum bestimmt und abhängig vom ermittelten Ionisationsgrad vom Prozessor ein Ausgangssignal abgegeben wird. Es kann auch vorgesehen sein, dass über einen Lichtsensor der Lichteinfall im Wägeraum bestimmt wird und, vorzugsweise, dass vom Prozessor ab einem vorgegebenen Lichteinfall ein Ausgangssignal abgegeben wird. Hinsichtlich der Vorteile wird auf die obigen Erläuterungen verwiesen.

Weitere Merkmale und Vorteile der Erfindung ergeben sich aus der nachfolgenden Beschreibung und aus den nachfolgenden Zeichnungen, auf die Bezug genommen wird. In den Zeichnungen zeigen:
- Figur 1 eine Explosionsansicht einer erfindungsgemäßen Komparatorwaage,
- Figur 2 eine Perspektivansicht eines Klimamoduls, das bei der erfindungsgemäßen Komparatorwaage eingesetzt werden kann,
- Figur 3 eine Seitenansicht des Klimamoduls nach Figur 2 ohne Außengehäuse,
- Figur 4 eine Draufsicht auf das Klimamodul von Figur 2, ebenfalls ohne Außengehäuse, und
- Figur 5 ein Ablaufdiagramm, das das erfindungsgemäße Verfahren wiedergibt.

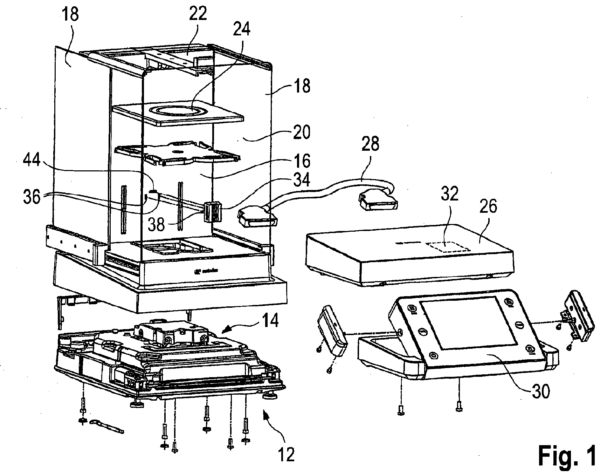

In Figur 1 ist eine hochauflösende elektronische Komparatorwaage dargestellt, die in diesem Ausführungsbeispiel Massevergleiche in den Genauigkeitsklassen E1 - F2 nach OIML R 111-1 ermöglicht.

Die Komparatorwaage umfasst eine Wägezelle 14 mit einer Basis 12, in welche ein nicht näher dargestelltes Wägesystem 10 untergebracht ist. Die Wägezelle 14 umfasst darüber hinaus einen Wägeraum 16, der durch einen Windschutz mit verstellbaren Seitenwänden 18, einer Frontwand 20 sowie einer Rückwand 22 ausgebildet ist. Über den Windschutz ist der Wägeraum 16 zur Umgebung abgetrennt. Eine Waagschale 24 dient zum Auflegen des Wägeguts.

Ein hier als separates Teil ausgeführtes elektronisches Auswertesystem 26 ist über ein Kabel 28 mit der Wägezelle 14 elektronisch gekoppelt. Eine Anzeigeeinheit 30, die mit dem Auswertesystem 26 gekoppelt ist, dient sowohl als Anzeige als auch als Dateneingabeeinheit.

Im elektronischen Auswertesystem 26 ist unter anderem ein Prozessor 32 untergebracht, der Daten von der Wägezelle 14 erhält.

Im Wägeraum 16 ist ein als baulich separate Einheit ausgeführtes Klimamodul 34 vorgesehen, welches über eine lösbare Steckverbindung mechanisch mit der Rückwand 22 koppelbar ist (also zerstörungsfrei lösbar angebracht ist), und zwar vorzugsweise ohne Zuhilfenahme eines Werkzeugs.

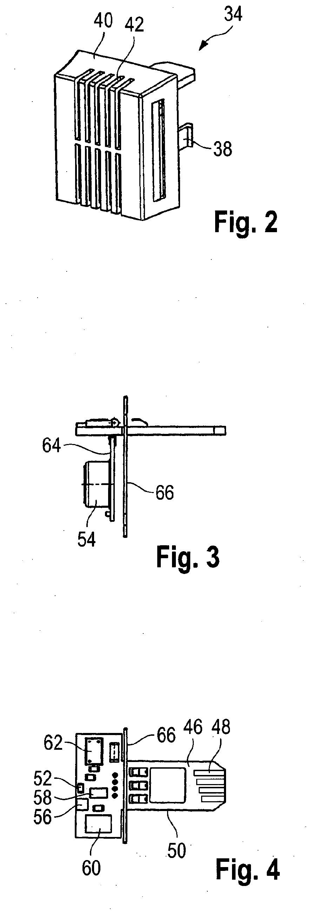

Hierzu weist die Rückwand 22 zwei voneinander beabstandete Schlitze 36 auf, in die flexible Rasthaken 38 (siehe auch Figur 2) am Außengehäuse 40 des Klimamoduls einrasten.

In den Figuren 2 bis 4 ist das Klimamodul 34 näher dargestellt.

Das Außengehäuse 40 hat zahlreiche Öffnungen 42, über die das Innere des Außengehäuses 40 in den Wägeraum 16 übergeht und Teil des Wägeraums 16 wird, sodass das Klima im Inneren des Wägeraums 16 dem im Inneren des Außengehäuses 40 entspricht.

Das Klimamodul 34 ist elektronisch über eine elektrische Steckverbindung mit einer entsprechenden Steckeraufnahme 44 in der Rückwand 22 gekoppelt. Die Steckeraufnahme 44 steht elektrisch mit dem Prozessor 32 in Verbindung. In die Steckeraufnahme 44 wird ein Stecker 46 mit Kontakten 48 am Klimamodul 34 eingesteckt. Somit bildet der Stecker 46 einen modulseitigen Teil der elektrischen Steckverbindung.

Alternativ zu einer elektrischen Steckverbindung kann eine Funkübertragung, beispielsweise WLAN oder Bluetooth, verwendet werden.

Die elektrische Steckverbindung (oder die alternativ verwendete Funkübertragung) bildet eine Datenübertragungsstrecke, mit der Daten vom Klimamodul 34 zum Prozessor 32 und ggfls. zurück übertragen werden können.

Der Stecker 46 ist vorzugsweise ein Abschnitt einer Leiterplatte 50, auf der mehrere Sensoren zum Erfassen des Klimas im Wägeraum 16 angeordnet sind. So sind ein Lufttemperatursensor 52, eine Luftfeuchtesensor 54, ein unmittelbar in der Nähe einer Öffnung 42 angeordneter Lichtsensor 56 sowie ein Sensor 58 zum Erfassen des Ionisationsgrads im Wägeraum 16 auf der Leiterplatte 50 vorgesehen, ebenso wie ein elektronischer Speicher 60. Ein Luftdrucksensor 62 ist über eine Halterung 64 mit der Leiterplatte 50 mechanisch und elektrisch gekoppelt.

Mehrere der Sensoren können auch zu kombinierten Sensoren zusammengefasst sein.

Eine Wand 66 schließt das schalenartige Außengehäuse 40, sodass der schmale, zungenartige, in Figur 4 rechts von der Wand 66 liegende Abschnitt der Leiterplatte 50 in die Rückwand 22 und die Steckeraufnahme 44 einsteckbar ist.

Über entsprechende Kontakte 48 ist jeder Sensor mit dem Prozessor 32 gekoppelt. Ebenso ist der Speicher 60 mit dem Prozessor 32 gekoppelt.

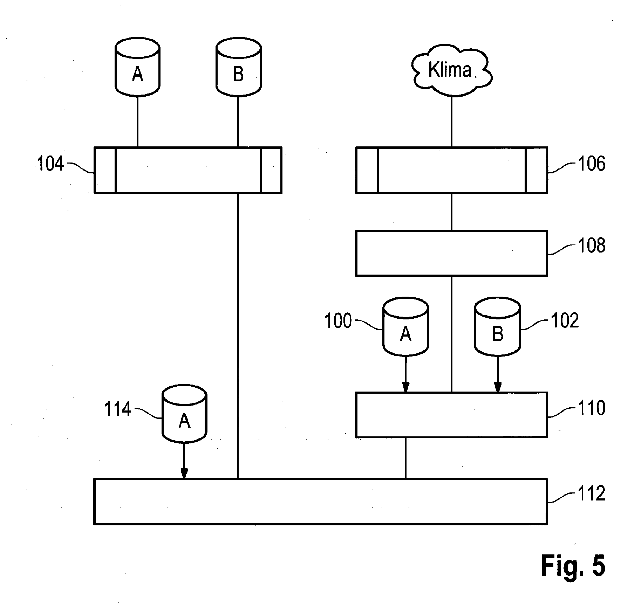

Die Komparatorwaage arbeitet nach folgendem Verfahren, das anhand von Figur 5 erläutert wird:
Die Dichte des Wägeguts (Prüfgewicht, auch Prüfling B genannt, und Referenzgewicht A) wird in den Schritten 100 und 102 in die Komparatorwaage eingegeben, beispielsweise über die Anzeigeeinheit 30, die gleichzeitig zum Beispiel auch über Touch-Screen als Dateneingabeeinheit dient. Alternativ kann die Dichte des Wägeguts bereits hinterlegt sein.

Ein Wägegut wird auf die Waagschale 24 aufgelegt, und zwar nach vorgegebenen Ablaufschritten, z.B. zuerst das Referenzgewicht A, anschließend zweimal der Prüfling B und schließlich wieder das Referenzgewicht A. Es handelt sich um eine Vergleichswägung, aus der im Schritt 104 sich die Anzeigedifferenz der Waage ergibt.

Der Luftdruck, die Luftfeuchte und die Lufttemperatur werden im Schritt 106 über die Sensoren 62, 54 bzw. 52 ermittelt, die entsprechenden Daten dann an den Prozessor 32 weitergeleitet.

Im Prozessor 32 wird die Luftdichte bestimmt, siehe Schritt 108. Mit den eingegebenen Dichten von Referenzgewicht A und Prüfling B wird im Prozessor der Luftauftriebskorrekturfaktor im Schritt 110 und/oder der Luftauftrieb des Wägeguts abhängig vom Luftdruck, der Luftfeuchte, der Lufttemperatur sowie der Dichte des Wägeguts ermittelt und im Schritt 112 der konventionelle Wägewert des Prüflings B, d.h. die um ihren Luftauftrieb korrigierte Masse des Prüflings B, bestimmt und als Protokoll in der Anzeigeeinheit 30 wiedergegeben, wobei die konventionelle Masse 114 des Referenzgewichts in die Bestimmung der konventionellen Masse des Prüflings mit eingeht.

Darüber hinaus sind im Speicher 60 Kalibrierwerte und Korrekturwerte für das Klimamodul 34 abgelegt, die beim Kalibrieren des Klimamoduls 34 hinterlegt wurden.

Dieses Kalibrieren erfolgt außerhalb der Komparatorwaage. Hierzu wird das Klimamodul 34 einfach vom Wägeraum 16 aus ausgesteckt, ohne dass eine Drahtverbindung gelöst werden müsste. Das Klimamodul 34 wird dann zu einem entsprechenden Kalibrierinstitut geschickt, das die Nummer des Kalibrierscheins, das heißt die neuen Kalibrierwerte, das Kalibrierdatum, den Namen des Kalibrierlabors und des Bearbeiters und die Kalibrierhistorie auf dem Speicher 60 ablegt. Diese Werte werden vom Applikationsprogramm später, wenn das Klimamodul 34 wieder in der Komparatorwaage ist, ausgelesen und fließen direkt in die Berechnung ein.

Auch die Werte des Lichtsensors 56 und des Sensors 58 zur Bestimmung des Ionisationsgrads im Wägeraum 16 werden bestimmt.

Beispielsweise wird bei erhöhtem Lichteinfall ein entsprechendes Signal auf der Anzeige angegeben werden, dass beispielsweise die Messung aufgrund erhöhter Sonneneinstrahlung und damit veränderter Temperatur im Wägeraum ungenau ist. Somit wird vom Prozessor ein Ausgangssignal abhängig vom Lichteinfall abgegeben.

Sobald der Ionisationsgrad zu hoch ist, wird eine Ionisationseinrichtung aktiviert, die die Luft im Wägeraum ionisiert und für eine Entladung des Wägeguts sorgt, oder es wird vor einer zu hohen Ladung des Wägeguts gewarnt.

Der Speicher 60 ist vorzugsweise ein EEPROM.

Darüber hinaus ist die Verbindung zwischen dem Klimamodul 34 und dem Rest der Komparatorwaage über einen I²C-BUS realisiert.

Das Klimamodul 34 kann über einen USB-Adapter, in den es eingesteckt wird, an einen Computer angeschlossen werden, um die Sensoren 52 bis 58 und 62 zu kalibrieren, ohne dass das Klimamodul 34 an die Komparatorwaage angeschlossen sein muss.

Wie zu erkennen ist, ist das Klimamodul so ausgebildet ist, dass es auch außerhalb einer Waage als selbständige Einheit einsetzbar ist und über einen I²C-Bus an einen USB-Port eines PC anschließbar ist.

## Patentansprüche

1. Komparatorwaage mit einem Wägeraum (16), einem Windschutz (18, 20, 22), der den Wägeraum (16) umgibt, einem Klimamodul (34), das einen Luftdrucksensor (62), einen Luftfeuchtesensor (54) und einen Lufttemperatursensor (52) enthält und abnehmbar in dem Wägeraum (16) angeordnet ist, einem Prozessor (32), der in der Komparatorwaage angeordnet ist, einer Dateneingabeeinheit, die an der Komparatorwaage angeordnet ist, und einer Datenübertragungsstrecke, die ausgebildet ist, Daten zwischen dem Klimamodul (34) und dem Prozessor (32) auszutauschen, wobei der Prozessor (32) so ausgebildet ist, dass er auf Basis der Dichte des Wägeguts aus dem Luftdruck, der Luftfeuchte und der Lufttemperatur im Wägeraum (16) den Luftauftrieb zumindest des Prüflings und/oder den Auftriebskorrekturfaktor ermittelt.

2. Komparatorwaage nach Anspruch 1, **dadurch gekennzeichnet, dass** das Klimamodul (34) mittels einer elektrischen Steckverbindung mit dem Prozessor (32) verbunden ist.

3. Komparatorwaage nach Anspruch 1, **dadurch gekennzeichnet, dass** das Klimamodul (34) mittels einer Funkübertragung mit dem Prozessor (32) gekoppelt ist.

4. Komparatorwaage nach einem der vorhergehenden Ansprüche, **dadurch gekennzeichnet, dass** im Klimamodul (34) ein Sensor (58), welcher mit dem Prozessor (32) gekoppelt ist, vorhanden ist und ausgebildet ist, den Ionisationsgrad im Wägeraum (16) zu bestimmen.

5. Komparatorwaage nach einem der vorhergehenden Ansprüche, **dadurch gekennzeichnet, dass** im Klimamodul (34) ein Lichtsensor (56) vorhanden ist, welcher mit dem Prozessor (32) gekoppelt ist.

6. Verfahren zum Betreiben einer Komparatorwaage nach einem der Ansprüche 1 bis 5, mit einem Wägeraum (16), der durch einen Windschutz zur Umgebung hin abgetrennt ist und in dem ein Luftdrucksensor (62), ein Luftfeuchtesensor (54) und ein Lufttemperatursensor (52) angeordnet sind, wobei die Sensoren (52, 54, 62) mit einem Prozessor (32) gekoppelt sind und wobei Wägegut in Form eines Prüflings (B) und wenigstens eines Referenzgewichts (A) gewogen werden, **gekennzeichnet durch** folgende Schritte:
- Ermitteln des Luftdruckes, der Luftfeuchte und der Lufttemperatur im Wägeraum (16) mithilfe der Sensoren (52, 54, 62),
- Eingabe der Dichte des Wägeguts in die Komparatorwaage, dessen Masse zu bestimmen ist,
- Ermitteln des Luftauftriebs zumindestdes Prüflings (B) und/oderdes Auftriebskorrekturfaktors aus dem Luftdruck, der Luftfeuchte, der Lufttemperatur und der Dichte des Wägeguts, und
- Bestimmen des korrigierten, konventionellen Wägewerts des Prüflings (B).

7. Verfahren nach Anspruch 6, **dadurch gekennzeichnet, dass** der Ionisationsgrad im Wägeraum (16) bestimmt wird und abhängig vom ermittelten lonisationsgrad vom Prozessor (32) ein Ausgangssignal abgegeben wird.

8. Verfahren nach einem der Ansprüche 6 und 7, **dadurch gekennzeichnet, dass** über einen Lichtsensor (56) im Wägeraum (16) der Lichteinfall bestimmt wird und, vorzugsweise, dass vom Prozessor (32) ab einem vorgegebenen Lichteinfall ein Ausgangssignal abgegeben wird.

9. Verfahren nach einem der Ansprüche 6 bis 8, **dadurch gekennzeichnet, dass** zumindest einige der Sensoren (52 - 58, 62) Teil eines separaten, vom Rest der Komparatorwaage (10) entkoppelbaren Klimamoduls (34) sind, das zur Kalibrierung von dem Rest der Komparatorwaage gelöst wird, wobei die Kalibrierwerte und Korrekturwerte auf einem Speicher (60) auf dem Klimamodul (34) abgelegtwerden.

## Claims

1. Comparator weighing machine with a weighing space (16), a wind protector (18, 20, 22) surrounding the weighing space (16), a climate module (34) which includes an air pressure sensor (62), a humidity sensor (54) and an air temperature sensor (52) and which is removably arranged in the weighing space (16), a processor (32) arranged in the comparator weighing machine, a data input unit arranged at the comparator weighing machine, and a data transmission path configured to exchange data between the climate module (34) and the processor (32), wherein the processor (32) is so constructed that on the basis of the density of the material to be weighed it determines from the air pressure, the humidity and the air temperature in the weighing space (16) the air lift of at least the test piece and/or the lift correction factor.

2. Comparator weighing machine according to claim 1, **characterised in that** the climate module (34) is connected with the processor (32) by means of an electrical plug connection.

3. Comparator weighing machine according to claim 1, **characterised in that** the climate module (34) is coupled with the processor (32) by means of radio transmission.

4. Comparator weighing machine according to any one of the preceding claims, **characterised in that** a sensor (58) coupled with the processor (32) is present in the climate module (34) and is constructed to determine the degree of ionisation in the weighing space (16).

5. Comparator weighing machine according to any one of the preceding claims, **characterised in that** a light sensor (56) coupled with the processor (32) is present in the climate module (34).

6. Method of operating a comparator weighing machine according to any one of claims 1 to 5, with a weighing space (16) which is separated from the environment by a wind protector and in which an air pressure sensor (62), a humidity sensor (54) and an air temperature sensor (52) are arranged, wherein the sensors (52, 54, 62) are coupled with a processor (32) and wherein weighing material in the form of a test piece (B) and at least one reference weight (A) are weighed, **characterised by** the following steps:
- determining the air pressure, humidity and air temperature in the weighing space (16) with the help of the sensors (52, 54, 62),
- input of the density of the weighing material, the mass of which is to be determined, into the comparator weighing machine,
- determining the air lift of at least the test piece (B) and/or the lift correction factor from the air pressure, the humidity, the air temperature and the density of the weighing material, and
- determining the corrected, conventional weighing value of the test piece (B).

7. Method according to claim 6, **characterised in that** the degree of ionisation in the weighing space (16) is determined and an output signal is issued by the processor (32) in dependence on the determined degree of ionisation.

8. Method according to one of claims 6 and 7, **characterised in that** the incidence of light is determined by way of a light sensor (56) in the weighing space (16) and preferably an output signal is issued by the processor (32) from a predetermined light incidence.

9. Method according to any one of claims 6 to 8, **characterised in that** at least some of the sensors (52 - 58, 62) are part of a separate climate module (34) which can be decoupled from the rest of the comparator weighing machine (10) and which for calibration is detached from the rest of the comparator weighing machine, wherein the calibration values and correction values are stored in a memory (60) at the climate module (34).

## Revendications

1. Balance comparatrice comprenant un compartiment de pesage (16), un pare-vent (18, 20, 22) entourant le compartiment de pesage (16), un module de climatisation (34) qui contient un capteur de pression d'air (62), un capteur d'humidité d'air (54) et un capteur de température d'air (52) et qui est disposé de façon amovible dans le compartiment de pesage (16), un processeur (32) disposé dans la balance de comparaison, une unité d'entrée de données disposée au niveau de la balance comparatrice, et un section de transmission de données conçue pour échanger des données entre le module de climatisation (34) et le processeur (32), le processeur (32) est conçu de façon à calculer, sur la base de la densité de l'objet à peser, à partir de la pression de l'air, de l'humidité de l'air et de la température de l'air dans le compartiment de pesage (16), la poussée aérostatique au moins de l'échantillon et/ou le facteur de correction de poussée.

2. Balance comparatrice selon la revendication 1, **caractérisée en ce que** le module de climatisation (34) est relié au processeur (32) au moyen d'une fiche de raccordement électrique.

3. Balance comparatrice selon la revendication 1, **caractérisée en ce que** le module de climatisation (34) est couplé au processeur (32) au moyen d'une liaison radio.

4. Balance comparatrice selon l'une quelconque des revendications précédentes, **caractérisée en ce qu'**un capteur (58) couplé au processeur (32) est présent dans le module de climatisation (34) et est conçu pour déterminer le degré d'ionisation dans le compartiment de pesage (16).

5. Balance comparatrice selon l'une quelconque des revendications précédentes, **caractérisée en ce qu'**un capteur de lumière (56) couplé au processeur (32) est présent dans le module de climatisation (34).

6. Procédé de fonctionnement d'une balance comparatrice selon l'une quelconque des revendications 1 à 5, comprenant un compartiment de pesage (16) séparé de son environnement par un pare-vent et dans lequel sont disposés un capteur de pression d'air (62), un capteur d'humidité d'air (54) et un capteur de température d'air (52), les capteurs (52, 54, 62) étant couplés à un processeur (32) et l'objet à peser sous la forme d'un échantillon (B) et d'au moins un poids de référence (A) étant pesés, **caractérisé par** les étapes suivantes consistant à:
- déterminer la pression de l'air, l'humidité de l'air et la température de l'air dans le compartiment de pesage (16) à l'aide des capteurs (52, 54, 62),
- saisir la densité de l'objet à peser, dont la masse est à déterminer, dans la balance comparatrice,
- déterminer la poussée aérostatique au moins de l'échantillon (B) et/ou le facteur de correction de poussée à partir de la pression de l'air, de l'humidité de l'air, de la température de l'air et de la densité de l'objet à peser, et
- déterminer la valeur de pesage conventionnelle corrigée de l'échantillon (B).

7. Procédé selon la revendication 6, **caractérisé en ce que** le degré d'ionisation dans le compartiment de pesage (16) est déterminé et un signal de sortie est délivré par le processeur (32) en fonction du degré d'ionisation déterminé.

8. Procédé selon l'une quelconque des revendications 6 et 7, **caractérisé en ce que** la lumière incidente est déterminée par un capteur de lumière (56) dans le compartiment de pesage (16) et, de préférence, **en ce qu'**un signal de sortie est délivré par le processeur (32) à partir d'une lumière incidente prédéterminée.

9. Procédé selon l'une quelconque des revendications 6 à 8, **caractérisé en ce qu'** au moins quelques-uns des capteurs (52-58, 62) font partie d'un module de climatisation (34) séparé qui peut être découplé du reste de la balance comparatrice (10) et qui est détaché du reste de la balance comparatrice pour l'étalonnage, les valeurs d'étalonnage et les valeurs de correction étant stockées dans une mémoire (60) du module de climatisation (34).
